# EUROPEAN PATENT SPECIFICATION

(11) **EP 2 251 369 B1**
(45) Date of publication and mention of the grant of the patent: **01.04.2015**
(21) Application number: 09716206.9
(22) Date of filing: 23.02.2009
(51) Int. Cl.: C08G 59/40, C08K 3/04, C08K 5/1515, C08K 9/06, C08L 63/00, H01H 45/02, H01L 23/29, H01L 23/31

(54) **ONE-PACK TYPE EPOXY RESIN COMPOSITION AND USE THEREOF**
EINZELPAKET-EPOXIDHARZZUSAMMENSETZUNG UND IHRE VERWENDUNG
COMPOSITION DE RÉSINE ÉPOXY DE TYPE À UN COMPOSANT ET SON UTILISATION

(30) Priority: 07.03.2008 JP 2008058178
(43) Date of publication of application: 17.11.2010
(73) Proprietor: Omron Corporation, Kyoto-shi, Kyoto 600-8530 (JP)
(72) Inventor: ITO, Mitsuo, Kyoto-shi, Kyoto 600-8530 (JP); FUKUHARA, Tomohiro, Kyoto-shi, Kyoto 600-8530 (JP); NAKAJIMA, Seiji, Kyoto-shi, Kyoto 600-8530 (JP)
(74) Representative: Giovannini, Francesca
(86) International application number: PCT/JP2009/053210
(87) International publication number: WO 2009/110345

(56) References cited:
- JP-A- 55 165 916
- JP-A- 56 155 222
- JP-A- 61 120 826
- JP-A- 2001 049 086
- JP-A- 2001 152 121
- JP-A- 2001 220 429
- JP-A- 2004 115 552
- JP-A- 2004 217 696
- Threebond: "Curing agents for epoxy resin", Technical news No.32 , 1 January 2006 (2006-01-01), XP002619345, Retrieved from the Internet: URL:http://www.threebond.co.jp/en/technica l/technicalnews/tech32.html [retrieved on 2011-01-27]

## Description

### Technical Field

The present invention relates to a one-pack type epoxy resin composition and use thereof. Particularly, the present invention relates to: a one-pack type epoxy resin composition containing, as its essential components, an epoxy resin, dicyandiamide, an epoxy resin adduct compound, and a non-latent imidazole compound so as to be capable of being cured at a low temperature and have an excellent heat resistance and sealing properties; an electronic component including at least two members adhered to each other by the one-pack type epoxy resin composition; and a sealing method for such an electronic component.

### Background Art

A miniature control relay (hereinafter, referred to as "relay") is a device for controlling an electric circuit by outputting an electric signal in accordance with conditions such as an electric quantity or a physical quantity. The relay is widely used in: electric home appliances such as televisions, microwave ovens, and air conditioners; machine tools; industrial machines such as machines for food products; transportation machinery and tools such as the ones related to automobiles and trains; and the like. Particularly, an increased number of relays are used in an electric/electronic component provided in a printed circuit board.

One of the properties required for the relay is maintenance of airtightness. Specifically, the relay is configured to have a formed member to which a metal terminal is adhered. In case the adhesion between the formed member and the metal terminal is inadequate, this may cause intrusion of a soldering flux and/or bad gas. This prevents the relay from maintaining a function of repeatedly causing ON and OFF at its contact. In order to avoid this, there is a strong demand for a sealing agent capable of providing a strong adhesion between the formed material and the metal terminal so as to maintain airtightness inside the relay.

Conventionally, an epoxy resin composition is generally used as a sealing agent. For a one-pack type epoxy resin composition (i.e., an epoxy resin composition of such a type in which an epoxy resin composition is premixed with a latent curing agent), dicyandiamide is generally used as the latent curing agent. For its alternative, the following latent curing agents, for example, have been proposed: a latent curing agent which is not dicyandiamide (e.g., an epoxy resin adduct compound) (Patent Literature 1); a mixture of dicyandiamide and a latent curing agent which is not dicyandiamide (Patent Literature 2); and a mixture of a latent imidazole compound and a latent curing agent such as dicyandiamide (Patent Literature 3).
Patent Literature 1: Japanese Patent Application Publication, Tokukai, No. 2001-207029 A (Publication Date: July 31, 2001)
Patent Literature 2: Japanese Patent Publication, No. 3797616 B (Registered on April 28, 2006)
Patent Literature 3: Japanese Patent Application Publication, Tokukai, No. 2004-115552 A (Publication Date: April 15, 2004)

### Summary of Invention

Recently, in consideration of safety and environmental impacts, a lead-free solder is more and more used. Accordingly, a temperature of a solder required for surface mounting of a relay on a printed circuit board is increased by 20°C to 30°C from a temperature (230°C to 240°C) conventionally required. Along with this, a sealing agent is also required to have a heat resistance for the increased temperature.

Further, except for a terminal material, a coil, a magnet, etc., constituent members of the relay are mainly made of plastic. Therefore, it is desirable that a curing temperature is 120°C or lower.

Thus, a sealing agent is required to be capable of being cured at a low temperature of 120°C or lower, and to improve adhesion between the formed member and the metal terminal so as to maintain airtightness in the relay even under a high-temperature processing condition for a soldering process.

However, dicyandiamide has the following problems: Since dicyandiamide is a compound having a high melting point, using dicyandiamide solely as the latent curing agent may result in unreacted substances remained, if curing is performed at a temperature of 120°C or lower. Further, a cured product obtained has an insufficient heat resistance. This causes poor airtightness.

Also, each of the latent curing agents described in Patent Literatures 1 to 3 has the following problem: Along with the use of a lead-free solder, a soldering processing temperature becomes high. This causes an insufficient heat resistance, thereby leading to poor airtightness.
"Curing agents for epoxy resin" (Technical news No.32, 01 January 2006) discloses compositions comprising an epoxy resin, a non-latent imidazole compound and dicyandiamide.
Patent document JP 2001/049086 discloses binder compositions comprising an epoxy resin, a phenolic novolac curing agent, dicyandiamide and a imidazole series hardening accelerator, wherein the imidazole compounds may be 2-heptadecylimidazole, 2-ethyl-4-methylimidazole, 2-phenyl-4,5-dihydroxymethylimidazole, 2,4-diamino-6-{2-dodecylimidazolyl(1)}ethyl-s-triazine, or 2,4-diamino-6-{2-dodecylimidazolyl (1)}ethyl-s-triazine isocyanuric acid.
Patent document JP 55165916 discloses an epoxy resin containing molten silica and beig cured with an imidazole compound by heat treatment at 150°C so that a one-pack type fast-curing heat resistant epoxy resin which is deformed at a temperature of larger than 250°C can be obtained. This document further discloses both latent and non-latent imidazole compounds.

The present invention was made in view of the foregoing problems, and an object of the present invention is to provide: a one-pack type epoxy resin composition which is capable of being cured at a low temperature and has excellent heat resistance and sealing properties; and use of the one-pack type epoxy resin composition.

The inventors of the present invention made a diligent study on a composition of a one-pack type epoxy resin composition which was capable of being cured at a low temperature and had excellent heat resistance and sealing properties. As a result, the inventors of the present invention found the following fact: It is possible to obtain a desired one-pack type epoxy resin composition by causing an epoxy resin to be mixed with dicyandiamide, an epoxy resin adduct compound, and a non-latent imidazole compound, each serving as a curing agent. Thus, the present invention was completed.

A one-pack type epoxy resin composition as claimed in claim 1 of the present invention contains an epoxy resin, dicyandiamide, an epoxy resin adduct compound, and at least one non-latent imidazole compound the invention also relates to its use as claimed in claim 5 and a relay sealing method as claimed in claim 6.

With this composition, dicyandiamide, which has a toughness giving effect, enhances the adhesion between the formed member and the metal terminal. Further, the epoxy resin adduct compound extends a pot life (working life) of the one-pack type epoxy resin composition and allows the one-pack type epoxy resin composition to be cured at a low temperature. Furthermore, the non-latent imidazole compound, which has a fast curing effect, accelerates curing between the formed material and the metal terminal, so as to improve the adhesion therebetween.

Therefore, the one-pack type epoxy resin composition of the present invention can be cured at a low temperature, and can exhibit a sufficient heat resistance even if a reflow or a flow using a lead-free solder is performed.

The one-pack type epoxy resin composition of the present invention is configured such that said at least one non-latent imidazole compound is selected from the group consisting of 1-cyanoethyl-2-methylimidazole, 1-cyanoethyl-2-ethyl-4-methylimidazole, 1-cyanoethyl-2-undecylimidazole, 1-cyanoethyl-2-phenylimidazole, 1-cyanoethyl-2-undecylimidazoliumtrimellitate, 1-cyanoethyl-2- phenylimidazoliumtrimellitate, 2,4-diamino-6-[2'-methylimidazolyl-(1')]-ethyl-s-triazine, a 2-phenylimidazole/isocyanuric acid adduct, 2-methylimidazole, 2-undecylimidazole, 2-phenyl-4-methylimidazole, 1-benzyl-2-methylimidazole, 1-benzyl-2-phenylimidazole, and 1,2-dimethylimidazole.

The one-pack type epoxy resin composition of the present invention preferably includes a wettability enhancer which has compatibility with an epoxy resin and contains, in a molecule, one or more hydroxyl groups and two or more glycidyl groups.

With this composition, since the wettability enhancer can enhance wettability of the one-pack type epoxy resin composition with respect to the members, it is possible to impart, to the one-pack type epoxy resin composition, wet spreading properties for a very narrow space. As a result, the one-pack type epoxy resin composition achieves fluidity even for a gap having a very narrow space (e.g., a gap of several µm or less). This enhances adhesion between members having a very narrow gap therebetween.

The one-pack type epoxy resin composition of the present invention preferably contains carbon black having acidic pH.

The acidic carbon black has not only excellent dispersibility but also a wettability enhancing effect. Therefore, the acidic carbon black can impart, to the one-pack type epoxy resin composition, wet spreading properties for a very narrow space. As a result, the one-pack type epoxy resin composition achieves fluidity even for a gap having a very narrow space (e.g., a gap of several µm or less). This enhances adhesion between members having a very narrow gap therebetween.

The one-pack type epoxy resin composition of the present invention is preferably configured such that: the one-pack type epoxy resin composition contains an inorganic filler having an average particle diameter of 10 nm or more but not more than 50 nm; the inorganic filler has been subjected to a surface treatment with a silane compound; and the silane compound contains, in a molecule, at least one alkoxyl group bound to a silicon atom and at least one alkyl group bound to a silicon atom, the alkyl group having a main chain whose number of carbon atoms is 16 or more but not more than 20.

The above inorganic filler has excellent dispersibility, and exhibits a fluidity control effect with respect to the one-pack type epoxy resin composition. This prevents the one-pack type epoxy resin composition from excessively flowing into a part which is not an adhesion surface.

An electronic component of the present invention is preferably configured to include at least two members adhered to each other by the one-pack type epoxy resin composition of the present invention. Further, it is preferable that the electronic component is a relay.

As described above, the one-pack type epoxy resin composition of the present invention has a high heat resistance. Therefore, the electronic component of the present invention can exhibit adequate airtightness even after a reflow or flow process using a lead-free solder. This prevents intrusion of a soldering flux and/or bad gas, thereby providing an electronic component having favorable properties.

An electronic component sealing method of the present invention preferably includes the step of: causing at least two members of an electronic component to adhere to each other by the one-pack type epoxy resin composition of the present invention, for airtight sealing or insulating sealing of the electronic component.

The one-pack type epoxy resin composition of the present invention, which has a high heat resistance, can enhance adhesion between members e.g., a formed member and a metal terminal of a relay. Further, even after a reflow or flow process using a lead-free solder, the one-pack type epoxy resin composition of the present invention can provide adequate airtight sealing or insulating sealing for the electronic component without decreasing the adhesion.

For a fuller understanding of the nature and advantages of the invention, reference should be made to the ensuing detailed description taken in conjunction with the accompanying drawings.

### Brief Description of Drawings

[Fig. 1] Fig. 1 is a view schematically illustrating an exterior appearance of a relay including a formed member to which a metal terminal is adhered.
[Fig. 2] Fig. 2 is a graph showing one example of a change in temperature of a solder observed during a reflow process.

### Reference Signs List

1 Formed member
2 Metal terminal
3 Surface on which a one-pack type epoxy resin composition is to be applied
   100 Relay

### Description of Embodiments

The following explains one embodiment of the present invention. However, the present invention is not limited to this.

### [1. One-Pack Type Epoxy Resin Composition]

### (1-1 One-Pack Type Epoxy Resin Composition)

A one-pack type epoxy resin composition of the present invention contains an epoxy resin, dicyandiamide, an epoxy resin adduct compound, and a non-latent imidazole compound.

The one-pack type epoxy resin composition refers to an epoxy resin composition in which an epoxy resin, a curing agent, and a curing accelerator are already mixed together. Further, the "one-pack type epoxy resin composition" is a concept used in contrast with a two-part epoxy resin composition. The two-part epoxy resin composition contains two separated components, (i) an epoxy resin and a mixture of curing agent/curing accelerator or (ii) a mixture of epoxy resin/curing accelerator and a curing agent. The two-part epoxy resin composition is used in such a manner that the two separated components are mixed together just before use.

The two-part epoxy resin composition has, for example, the following disadvantages: (i) poor curing is apt to occur due to mismeasurement in the mixing; and (ii) a pot life after the mixing is short. Further, in a case where the curing agent is made of polyamidoamine, aliphatic amine, or the like, a cured product having a low heat resistance is given. This often causes poor airtightness after a soldering process. Recently, in order to avoid this, the one-pack type epoxy resin composition is more and more used, because the one-pack type epoxy resin composition causes less material loss and provides high productivity.

The epoxy resin refers to an epoxy resin which is in a liquid phase around room temperature and which has (i) an aromatic ring or a hydrogenerated aromatic ring such as a benzene ring, a naphthalene ring, or a hydrogenerated benzene ring and (ii) two or more terminal epoxy groups. The aromatic ring or the hydrogenerated aromatic ring may have a substituent (e.g., alkyl or halogen) bound thereto.

The terminal epoxy group and the aromatic ring or the hydrogenerated aromatic ring are bound to each other through e.g., oxyalkylene, poly(oxyalkylene), carboxyalkylene, carbopoly(oxyalkylene), or aminoalkylene. Further, the aromatic ring or the hydrogenerated aromatic ring is bound to a carbon atom directly or through e.g., alkylene, oxyalkylene, or poly(oxyalkylene).

Specific examples of the epoxy resin encompass: bisphenol-A diglycidylether; bisphenol-A ethylene oxide 2-mol adduct diglycidylether; bisphenol-A-1,2-propyleneoxide 2-mol adduct diglycidylether; hydrogenerated bisphenol-A diglycidylether; orthophthalic acid diglycidylester; tetrahydroisophthalic acid diglycidylester; N,N-diglycidylaniline; N,N-diglycidyltoluidine; N,N-diglycidylaniline-3-glycidylether; tetraglycidylmetaxylenediamine; 1,3-bis(N,N-diglycidylaminomethylene)cyclohexane; and tetrabromobisphenol-A diglycidylether.

The present invention uses one or more kinds selected from the group including these epoxy resins. When two or more kinds are used in combination, a ratio therebetween may optionally be determined. In consideration of a heat resistance of a cured product, it is preferable to use bisphenol-A diglycidylether and/or hydrogenerated bisphenol-A diglycidylether, etc.

Dicyandiamide is a single compound. Dicyandiamide is a compound which has a toughness giving effect and is widely used as a latent curing agent. However, dicyandiamide has a high melting point (melting point: approximately 180°C to 200°C). Therefore, if curing is performed at a low curing temperature of 120°C or lower, which low curing temperature is required to manufacture an electronic component such as a relay, unreacted substances may be remained. This causes poor airtightness in an electronic component.

On the other hand, the one-pack type epoxy resin composition of the present invention contains, as its essential components, an epoxy resin, dicyandiamide, an epoxy resin adduct compound, and a non-latent imidazole compound. In such the one-pack type epoxy resin composition of the present invention, the epoxy resin adduct compound and the non-latent imidazole compound melt dicyandiamide, so as to accelerate curing of dicyandiamide at a low temperature of 120°C or lower. This makes it possible to avoid poor airtightness caused by unreacted dicyandiamide remained. Not only that, the toughness giving effect, which dicyandiamide inherently has, strengthens adhesion between members constituting an electronic component.

The epoxy resin adduct compound refers to a curing agent which is stable even in a mixture system with an epoxy resin and which provides a cured product of a high heat deflection temperature by being subjected to a thermal treatment at 80°C or higher but not higher than 120°C together with the epoxy resin. Note that the "high heat deflection temperature" herein refers to a temperature of 170°C or higher.

The epoxy resin adduct compound is a solid insoluble in a general liquid epoxy resin around room temperature. However, once heated, the epoxy resin adduct compound becomes soluble, so as to exhibit its inherent function. For example, the epoxy resin adduct compound exhibits a function of extending a pot life of the one-pack type epoxy resin composition. Specifically, as described above, the epoxy resin adduct compound melts dicyandiamide, so as to accelerate curing of dicyandiamide, thereby enabling adequate curing at a low temperature of around 120°C. s

Here, the "heat deflection temperature" is measured as follows: A test specimen is loaded with a certain deflecting weight (4.6 kgf/cm² or 18.6 kgf/cm²) on its center, and the test specimen is gradually heated at a certain rate. Then, a temperature at which distortion at the center of the test specimen reaches 0.2 mm is determined as a heat deflection temperature. Note that the heat deflection temperature is also referred to as "deflection temperature under load".

Examples of the epoxy resin adduct compound encompass an epoxy resin/amine adduct compound, an epoxy resin/imidazole adduct compound, and a modified aliphatic polyamine compound.

The epoxy resin/amine adduct compound basically means a reaction product (generally referred to as epoxy compound/amine adduct) of an epoxy compound and an amine compound. Specifically, the epoxy resin/amine adduct compound refers to a reaction product (i.e., epoxy compound/amine adduct) of an epoxy compound and an amine compound which contains, in one molecule, one or more active hydrogens capable of addition reaction with an epoxy group of a monofunctional epoxy compound and an epoxy group of a polyfunctional epoxy compound and which contains, in a molecule, at least one substituent selected from a primary amino group, a secondary amino group, and a tertiary amino group.

Examples of such an epoxy compound and such an amine compound encompass aliphatic, alicyclic, aromatic, and heterocyclic epoxy compounds and amine compounds. Therefore, a chemical structure of the epoxy compound/amine adduct is not fixed to any specific one. Examples thereof are described in the following Japanese Patent Application Publications: Tokukaisho, No. 56-155222 A; Tokukaisho, No. 57-100127 A; Tokukaisho, No. 61-228018 A; Tokukaisho, No. 62-285913 A; Tokukaisho, No. 64-70523 A; Tokukaihei, No. 3-139517 A; Tokukaihei, No. 6-49176 A; Tokukaihei, No. 6-211969 A; and Tokukaihei, No. 7-196776 A.

The following lists examples of a commercially-available epoxy resin/amine adduct compound: AMICURE (Registered Trademark) MY-24, MY-R (both available from Ajinomoto Fine-Techno Co., Inc.); NOVACURE (Registered Trademark) HX-3721, HX-3742 (both available from Asahi Kasei Corporation); Hardener H-3293S, H-3615S (both available from ACR); and ANCAMINE (Registered Trademark) 2014AS, 2014FG (both available from Pacific Anchor Chemical Corporation). However, the present invention is not limited to these. As the epoxy resin/amine adduct compound, one kind may solely be used. Alternatively, two or more kinds may be used in combination. When two or more kinds are used in combination, a ratio therebetween may optionally be determined.

The epoxy resin/imidazole adduct compound refers to a curing agent which is stable even in a mixture system with an epoxy resin and which provides a cured product of a high heat deflection temperature by being subjected to a thermal treatment at 80°C or higher but not higher than 120°C together with the epoxy resin. The epoxy resin/imidazole adduct compound is a solid insoluble in a general liquid epoxy resin around room temperature. However, once heated, the epoxy resin/imidazole adduct compound becomes soluble, so as to exhibit its inherent function.

The epoxy resin/imidazole adduct compound basically means a reaction product (generally referred to as epoxy compound/imidazole adduct) of an epoxy compound and an imidazole compound. Specifically, the epoxy resin/imidazole adduct compound refers to a reaction product (i.e., epoxy compound/imidazole adduct) of an epoxy compound and an imidazole compound which contains, in one molecule, one or more active hydrogens capable of addition reaction with an epoxy group of a monofunctional epoxy compound and an epoxy group of a polyfunctional epoxy compound and which contains, in at least one molecule, one or more imidazole groups.

Examples of such an epoxy compound and such an imidazole compound encompass aliphatic, alicyclic, aromatic, and heterocyclic epoxy compounds and imidazole compounds. Therefore, a chemical structure of the epoxy compound/imidazole adduct is not fixed to any specific one. Examples thereof are described in the following Japanese Patent Application Publications: Tokukaisho, No. 62-285913 A; Tokukaihei, No. 3-139517 A; Tokukaihei, No. 6-49176 A; Tokukaihei, No. 6-211969 A; and Tokukaihei, No. 7-196776 A.

The following lists examples of a commercially-available epoxy resin/imidazole adduct compound: AMICURE (Registered Trademark) PN-23, PN-R (both available from Ajinomoto Fine-Techno Co., Inc.). However, the present invention is not limited to these. As the epoxy resin/imidazole adduct compound, one kind may solely be used. Alternatively, two or more kinds may be used in combination. When two or more kinds are used in combination, a ratio therebetween may optionally be determined.

The modified aliphatic polyamine compound refers to a curing agent which is stable even in a mixture system with an epoxy resin and which provides a cured product of a high heat deflection temperature by being subjected to a thermal treatment at 80°C or higher but not higher than 120°C together with the epoxy resin. The modified aliphatic polyamine compound is a solid insoluble in a general liquid epoxy resin around room temperature. However, once heated, the modified aliphatic polyamine compound becomes soluble, so as to exhibit its inherent function. The modified aliphatic polyamine compound basically means a reaction product (generally referred to as aliphatic polyamine modification product) of an amine compound and an isocyanate compound. Specifically, the modified aliphatic polyamine compound refers to a reaction product (i.e., aliphatic polyamine modification product) of (i) a dialkylaminoalkylamine compound, (ii) a cyclic amine compound containing, in a molecule, one or more nitrogen atoms each having an active hydrogen, and (iii) a diisocyanate compound.

Alternatively, an aliphatic polyamine modification product obtained by reacting the above three components with an epoxy compound serving a fourth component is also possible. Therefore, a chemical structure of the aliphatic polyamine modification product is not fixed to any specific one. Examples thereof are described in the following Publications: Japanese Examined Patent Application Publication, Tokukosho, No. 58-55970 B; Japanese Patent Application Publication, Tokukaisho, No. 59-27914 A; Japanese Patent Application Publication, Tokukaisho, No. 59-59720 A; and Japanese Patent Application Publication, Tokukaihei, No. 3-296525 A.

A commercially-available modified aliphatic polyamine compound is, for example, FUJICURE (Registered Trademark) FXE-1000 (available from Fuji Kasei Kogyo Co., Ltd.). However, the present invention is not limited to this.

As the epoxy resin adduct compound, the epoxy resin/amine adduct compound, the epoxy resin/imidazole adduct compound, the modified aliphatic polyamine compound, or the like may solely be used. Alternatively, a mixture thereof may be used. When these are used in combination, a ratio therebetween may optionally be determined.

The non-latent imidazole compound refers to an imidazole compound whose initial viscosity is doubled within 30 days if stored at 25°C and which is not included in a latent curing agent. That is, the non-latent imidazole compound can be any of imidazole compounds excluding latent imidazole compounds. Here, the "initial viscosity" is obtained as follows: A certain amount of curing agent is added to a liquid epoxy resin, and the resultant is stirred. Immediately after the stirring, a viscosity is measured in the mixture system at 25°C as the initial viscosity. Changes in the initial viscosity and a viscosity can be measured with a B-type viscometer.

The latent curing agent refers to a curing agent which is stable in a mixture system with an epoxy resin. Further, the latent curing agent is a compound which does not have activity for curing the epoxy resin at room temperature, but is activated in response to e.g., dissolution, decomposition, or a transfer reaction occurred upon heating, so as to function as a curing accelerator for the epoxy resin. Examples of the latent curing agent encompass dicyandiamide, organic acid dihydrazide, an epoxy resin adduct compound, a urea compound, a modified aliphatic polyamine compound, a tertiary amine compound, and an aminododecanoic acid.

The latent imidazole compound refers to, among imidazole compounds, a compound which functions as a latent curing agent. Examples of the latent imidazole compound encompass: 2-phenyl-4,5-dihydroxymethylimidazol; 2-phenyl-4-methyl 5-hydroxymethylimidazole; a 2,4-diamino-6-[2'-methylimidazolyl-(1')]-ethyl-s-triazinelisocyanuric acid adduct; and 2-phenylimidazole.

The non-latent imidazole compound are 1-cyanoethyl-2-methylimidazole; 1-cyanoethyl-2-ethyl-4-methylimidazole; 1-cyanoethyl-2-undecylimidazole; 1-cyanoethyl-2-phenylimidazole; 1-cyanoethyl-2-undecylimidazoliumtrimellitate; 1-cyanoethyl-2-phenylimidazoliumtrimellitate; 2,4-diamino-6-[2'-methylimidazolyl-(1')]-ethyl-s-triazine; a 2-phenylimidazole/isocyanuric acid adduct; 2-methylimidazole; 2-undecylimidazole; 2-phenyl-4-methylimidazole; 1-benzyl-2-methylimidazole; 1-benzyl-2-phenylimidazole; and 1,2-dimethylimidazole. In the present invention, it is preferable to use one or more kinds selected from the group including these non-latent imidazole compounds. When two or more kinds are used in combination, a ratio therebetween may optionally be determined.

The non-latent imidazole compound has fast curing properties, since it is not the latent curing agent. For this reason, the non-latent imidazole compound can accelerate curing of an epoxy resin, thereby enhancing adhesion between members of an electronic component, e.g., adhesion between a formed member and a metal terminal each of which is a constituent member of a relay.

Use of the non-latent imidazole compound can provide even more excellent low-temperature curing properties and fast curing properties, which cannot be attained with the latent imidazole compound. Further, due to its low-temperature curing properties, the non-latent imidazole compound can melt a curing agent having a high melting point. Furthermore, due to its low-temperature fast curing properties, the non-latent imidazole compound can reduce a damage given to an electronic component. Moreover, by melting dicyandiamide to accelerate curing thereof as described above, the non-latent imidazole compound enables adequate curing of dicyandiamide at a low temperature of 120°C or lower.

As described above, the one-pack type epoxy resin composition of the present invention includes the following components: the epoxy resin; dicyandiamide; the epoxy resin adduct compound; and the non-latent imidazole compound.

Each of dicyandiamide, the epoxy resin adduct compound, and the non-latent imidazole compound is conventionally known as a curing agent. However, as shown in the later-described Comparative Examples, mixing any single one of these three components with an epoxy resin does not allow a relay to maintain airtightness. Similarly, combining every two components out of the three components does not allow a relay to maintain airtightness.

That is, in a case where every single one of dicyandiamide, the epoxy resin adduct compound, and the non-latent imidazole compound is used, or in a case where only two components of these are used in combination, it is impossible to provide a one-pack type epoxy resin composition which allows an epoxy resin to be cured at a low temperature and has a high heat resistance.

The one-pack type epoxy resin composition of the present invention has a specificity in that it includes, as its essential components, dicyandiamide, the epoxy resin adduct compound, and the non-latent imidazole compound in combination, with respect to the epoxy resin. This gives an unexpected synergistic effect, thereby providing a one-pack type epoxy resin composition capable of being cured at a low temperature of 120°C or lower and having a high heat resistance, which cannot be achieved with conventional art. This allows an electronic component to maintain airtightness even after a process using a lead-free solder.

If an amount of the curing agent mixed in the one-pack type epoxy resin composition of the present invention is too small, inadequate curing is caused. On the other hand, if an amount of the curing agent mixed in the one-pack type epoxy resin composition of the present invention is too large, a viscosity is increased, so that processability is impaired. Therefore, the one-pack type epoxy resin composition of the present invention preferably contains, with respect to 100 parts by weight of epoxy resin, dicyandiamide in an amount ranging from 1 to 30 parts by weight, more preferably from 1 to 10 parts by weight; the epoxy resin adduct compound in an amount ranging from 1 to 30 parts by weight, more preferably from 1 to 10 parts by weight; and the non-latent imidazole compound in an amount ranging from 1 to 30 parts by weight, more preferably from 1 to 10 parts by weight.

### (1-2. Wettability Enhancer)

The one-pack type epoxy resin composition of the present invention preferably contains a wettability enhancer which has compatibility with an epoxy resin and contains, in a molecule, one or more hydroxyl groups and two or more glycidyl groups.

By adding the wettability enhancer to the one-pack type epoxy resin composition, it is possible to enhance wettability of the one-pack type epoxy resin composition, thereby allowing the one-pack type epoxy resin composition to have fluidity for a gap having a very narrow space (e.g., a gap of several µm or less).

The wettability enhancer only needs to have compatibility with an epoxy resin and contain, in a molecule, one or more hydroxyl groups and two or more glycidyl groups, and thus is not limited to any specific one. The following lists examples of a monoepoxy compound: i-propylglycidylether; n-butylglycidylether; t-butylglycidylether; 2-ethylhexylglycidylether; laurylglycidylether; phenylglycidylether; p-cresylglycidylether; p-t-butylphenylglycidylether; benzylglycidylether; diethyleneglycol-t-butyletherglycidylether; diethyleneglycol-2-ethylhexyletherglycidylether; lauric acid glycidylester; oleic acid glycidylester; linoleic acid glycidylester; and 7-hydroxy oleic acid glycidylester.

The following lists examples of a diepoxy compound: glycerin diglycidylether; polyethyleneglycol diglycidylether; polypropyleneglycol diglycidylether; neopentylglycol diglycidylether; and 1 ,6-hexanediol diglycidylether.

The following lists examples of a triepoxy compound: trimethylolpropane triglycidylether; and triphenylolmethane triglycidylether.

By adding such a wettability enhancer to the one-pack type epoxy resin composition of the present invention, it is possible to reduce a viscosity of the one-pack type epoxy resin composition to one-severalth to one-tenth without affecting curing properties of the one-pack type epoxy resin composition, while enhancing wettability thereof.

The present invention uses one or more kinds selected from the group including these epoxy resins. When two or more kinds are used in combination, a ratio therebetween may optionally be determined. As the wettability enhancer which has compatibility with an epoxy resin and contains, in a molecule, one or more hydroxyl groups and two or more glycidyl groups, it is preferable to use e.g., bisphenol-F diglycidylether, and/or glycerin diglycidylether.

A content of the wettability enhancer is preferably within a range of 1 part by weight or more but not more than 100 parts by weight, more preferably 5 parts by weight or more but not more than 80 parts by weight, with respect to 100 parts by weight of an epoxy resin.

A method for mixing the wettability enhancer with the one-pack type epoxy resin composition is not limited to any specific one. The mixing can be performed using a conventionally-known device such as a kneader or a mixing roll as needed.

What is meant by the above expression "having compatibility" is that a wettability enhancer and an epoxy resin have affinity with respect to each other and form a solution or a mixture.

### (1-3. Carbon Black)

The one-pack type epoxy resin composition of the present invention preferably contains carbon black having acidic pH.

The carbon black refers to spherical or chain-like carbon which is in the form of fine powders and which is produced by gas-phase pyrolysis or incomplete combustion of natural gas or hydrocarbon gas. Depending on its manufacturing method, the carbon black is categorized into the following types: channel black, furnace black, thermal black, lamp black, and the like. However, the type of the carbon black used in the present invention is not limited to any specific one.

The carbon black, which is in the form of microparticles (average particle diameter: approximately 10 nm to 100 nm), has a considerably strong aggregation, and therefore is difficult to disperse in medium. Further, even if the carbon black disperses in medium once, the carbon black immediately aggregates together again. In order to deal with this, the following measures are being considered: (i) a dispersing agent is added to medium before dispersing the carbon black; and (ii) dispersion is performed in such a manner that a dispersing agent and the carbon black are mixed in at once. Also, use of various kinds of dispersing agents is being considered.

However, the carbon black often fails to adequately adhere to a surface of medium, since the carbon black has a specific surface condition. Therefore, it is extremely difficult to find a satisfactory dispersing agent.

In view of this, the present invention uses carbon black whose pH is in an acidic region. As the carbon black, carbon black having been subjected to an oxidation treatment with various oxidizing agents is generally used. Such carbon black preferably has pH 6.5 or lower, more preferably pH 5.0 or lower, further preferably pH 2.0 or higher but not higher than pH 4.0. The oxidation treatment for the carbon black is generally achieved by (i) a gas-phase treatment with e.g., air, NOx, oxygen, or ozone or (ii) a liquid-phase treatment with e.g., potassium dichromate, hydrogen peroxide, sodium hypochlorite, or a nitric acid. Here, what is meant by the expression "carbon black having acidic pH" is that a surface and an inside of the carbon black are acidic.

By setting pH to an acidic region (especially preferably pH 2.0 or higher but not higher than pH 4.0), it is possible to achieve carbon black having excellent dispersibility with respect to the one-pack type epoxy resin composition. Therefore, mixing the carbon black with the one-pack type epoxy resin composition allows the one-pack type epoxy resin composition to have enhanced wettability with respect to a member. Consequently, it is possible to impart, to the one-pack type epoxy resin composition, fluidity for a gap having a very narrow space (e.g., a gap of several µm or less).

A method for mixing the carbon black with the one-pack type epoxy resin composition is not limited to any specific one, and may use a conventionally-known method. Examples of the method encompass a method for kneading with use of a mixing roll or a kneader.

A content of the carbon black is preferably within a range of 0.1 parts by weight or more but not more than 5 parts by weight, more preferably within a range of 0.1 parts by weight or more but not more than 2 parts by weight, with respect to 100 parts by weight of an epoxy resin.

A method for mixing the carbon black with the one-pack type epoxy resin composition is not limited to any specific one. The mixing may be performed by using a conventionally-known device such as a kneader or a mixing roll as needed.

### (1-4. Inorganic Filler Subjected to Surface Treatment)

The one-pack type epoxy resin composition of the present invention preferably contains an inorganic filler having an average particle diameter of 10 nm or more but not more than 50 nm, the inorganic filler having been subjected to a surface treatment with a silane compound containing, in a molecule, at least one alkoxyl group bound to a silicon atom and at least one alkyl group bound to a silicon atom, the alkyl group having a main chain whose number of carbon atoms is 16 or more but not more than 20.

Mixing a large amount of an inorganic filler having a particle diameter of several µm or more in the one-pack type epoxy resin composition of the present invention increases the viscosity, so as to impair the processability. In view of this, the inorganic filler of the present invention is preferably an inorganic filler having an average particle diameter of 10 nm or more but not more than 50 nm. This is because that, even by adding just a small amount of such the inorganic filler to the one-pack type epoxy resin composition, it is possible to prevent the one-pack type epoxy resin composition from excessively flowing into a part which is not an adhesion surface.

Note that the average particle diameter can be adjusted to be within the range of 10 nm or more but not more than 50 nm, for example, by the following method: An inorganic filler is hydrolyzed (or decomposed through oxidation) in a high-temperature oxyhydrogen flame (or by indirect heating in an oxygen atmosphere) at 1000°C to 1200°C, so that a loosely-bound aggregation being in the form of soot is formed once. The aggregation is heated and melted at a temperature of 1800°C or higher, and is then cooled for randomly binding it again. In this way, it is possible to adjust the average particle diameter to be within the range of 10 nm or more but not more than 50 nm.

It is preferable that the inorganic filler has been subjected to a surface treatment with a silane compound containing, in a molecule, at least one alkoxyl group bound to a silicon atom and at least one alkyl group bound to a silicon atom, the alkyl group having a main chain whose number of carbon atoms is 16 or more but not more than 20. This surface treatment enhances (i) dispersibility of the inorganic filler with respect to the one-pack type epoxy resin composition and (ii) a binding force between the one-pack type epoxy resin composition and the inorganic filler. Therefore, the inorganic filler having been subjected to the surface treatment can efficiently control the fluidity of the one-pack type epoxy resin composition.

As described above, since the inorganic filler having the average particle diameter of 10 nm or more but not more than 50 nm and having been subjected to the surface treatment has excellent dispersibility with respect to a one-pack type epoxy resin composition, addition of even just a small amount of such the inorganic filler to a one-pack type epoxy resin composition can control the fluidity of the one-pack type epoxy resin composition. This prevents the one-pack type epoxy resin composition from excessively flowing into a part which is not an adhesive surface.

The silane compound capable of the surface treatment with respect to the inorganic filler contains, in a molecule, at least one alkoxyl group and at least one alkyl group. Further, out of four bindings of a silicon atom in the silane compound, one to three binding(s) is/are made with an alkoxyl group(s), and the other three to one binding(s) is/are made with nonhydrolyzable or hardly-hydrolyzable alkyl group(s) of the same kind or of different kinds. The alkyl group has a main chain whose number of carbon atoms is 16 or more but not more than 20. In a case where the number of carbon atoms in the main chain is below 14, an effect achieved by the surface treatment becomes small. On the other hand, in a case where the number of carbon atoms in the main chain exceeds 22, a rate of the hydrolysis becomes slower, thereby making it difficult to perform a uniform surface treatment.

Examples of the alkyl group encompass a palmitoyl group, a stearyl group, and a decyl group.

The alkoxyl group is not limited to any specific one, examples of which encompass a conventionally-known alkoxyl group such as a methoxy group and an ethoxyl group.

As the silane compound, for example, hexadecyltrimethoxysilane or octadecyltriethoxysilane may be used.

The inorganic filler used for the surface treatment is not limited to any specific one. Examples thereof encompass fused silica, crystalline silica, talc, alumina, silicon nitride, calcium carbonate, and calcium silicate. Of these, only one kind may be used. Alternatively, two or more kinds may be used in combination. When two or more kinds are used in combination, a ratio therebetween may optionally be determined. Of these, silica is preferable because it exhibits excellent thermal expansion and thermal conduction.

The surface treatment can be performed, for example, as follows: A treatment agent prepared by dilution of the silane compound is caused to be present on a surface of an inorganic oxide powder and heated to 200 °C or higher.

As the treatment agent, for example, the one obtained by dissolving the silane compound in a solvent together with a catalyst may be used. Examples of the catalyst encompass: amines such as triethylamine, diethylamine, and ethylenediamine; and an acetic acid. The solvent is selected according to the type of alkylsilane. For example, the solvent is preferably selected from hexane, toluene, alcohols, and ethers, in each of which long-chain alkylsilane is easily dissolved.

Use of the silane compound together with the catalyst proceeds a hydrolysis reaction of the silane compound, so as to accelerate fixing of the silane compound onto the surface of the inorganic oxide powder. A method for causing the treatment agent to be present on the surface of the inorganic oxide powder is achieved by any suitable method, examples of which encompass: a method in which the treatment agent is sprayed onto the inorganic oxide powder; and a method in which the inorganic oxide powder is immersed in a solution of the treatment agent. The surface treatment is preferably performed in a nitrogen atmosphere.

Performing the heating process accelerates a binding reaction between the treatment agent and the surface of the inorganic oxide. A temperature for the heating is suitably 200°C or higher but not higher than 400°C.

A content of the inorganic filler having been subjected to the above surface treatment is preferably within a range of 0.1 parts by weight or more but not more than 30 parts by weight, more preferably within a range of 0.1 parts by weight or more but not more than 10 parts by weight, with respect to 100 parts by weight of an epoxy resin.

A method for mixing, in the one-pack type epoxy resin composition, the inorganic filler having been subjected to the above surface treatment is not limited to any specific one. The mixing can be performed by using a conventionally-known device such as a kneader or a mixing roll as needed.

### (1-5. Other Compounding Agents, Additives)

Further, if necessary, the one-pack type epoxy resin composition of the present invention may be additionally mixed with a compounding agent and/or an additive such as a filler, a colorant, a flame retardant, a light stabilizer, a reinforcer, a thickener, a viscosity modifier, and/or a thixotropy-imparting agent, in such an amount which does not impair the effects of the present invention. Such a compounding agent and/or additive is not limited to any special one limited to the present invention, but may be optionally selected from general ones used in conventional one-pack type epoxy resin compositions. For example, each of the later-described Examples used calcium carbonate as a filler.

The one-pack type epoxy resin composition of the present invention can be manufactured by mixing together the epoxy resin, dicyandiamide, the epoxy resin adduct compound, the non-latent imidazole compound, and, if necessary, other compounding agent and/or additive, in accordance with a conventionally-used manufacturing method for a one-pack type epoxy resin composition.

### [2. Use of One-Pack Type Epoxy Resin Composition of the Present Invention]

The one-pack type epoxy resin composition of the present invention can be suitably used as a sealing agent for airtight sealing or insulating sealing of an electronic component. An electronic component of the present invention includes at least two members adhered to each other by the one-pack type epoxy resin composition of the present invention.

The "electronic component" only needs to be the one for which airtight sealing and/or insulating sealing is/are effective, and thus is not limited to any specific one. The "electronic component" may be the one generally called "electric component". Examples thereof encompass a relay, a switch, and a sensor.

What is meant by the expression "at least two members adhered to each other by the one-pack type epoxy resin composition" is that the one-pack type epoxy resin composition exists between said at least two members and provides an adhesive force by which said at least two members are caused to bind to each other.

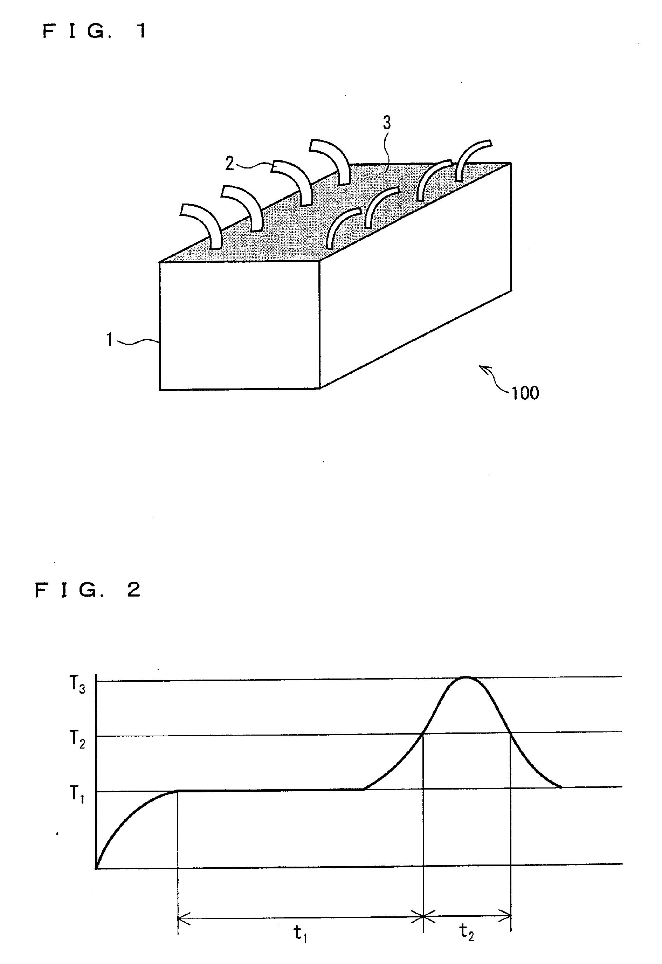

A subject member for the adhesion is not limited to any specific one. For example, such a case is possible that the one-pack type epoxy resin composition adheres a formed member of a relay to a metal terminal of the relay. Fig. 1 is a view schematically illustrating an exterior appearance of a relay including a formed member to which a metal terminal is adhered. In Fig. 1, a relay 100 is constituted by a formed member 1 and a metal terminal 2 when viewed from the outside. The formed member 1 internally stores components such as a coil and a switch (not illustrated). The formed member 1 has a surface 3 on which a one-pack type epoxy resin composition is to be applied.

A method for causing members to adhere to each other by the one-pack type epoxy resin composition of the present invention is not limited to any specific one. For example, the following method is possible: The one-pack type epoxy resin composition is applied to the whole of or part of at least one member, said at least one member is brought into close contact with another member that is to be adhered, and then the one-pack type epoxy resin composition is cured.

In the case of Fig. 1, the following method is possible: A necessary amount of the one-pack type epoxy resin composition is applied to the surface 3 on which a one-pack type epoxy resin composition is to be applied, a surface of the metal terminal 2 is brought into close contact with the surface 3 on which a one-pack type epoxy resin composition is to be applied, and then the one-pack type epoxy resin composition is cured. Note that the "necessary amount" varies according to the type of the electronic component.

The one-pack type epoxy resin composition can be cured by heating the one-pack type epoxy resin composition. A temperature for the heating is not particularly limited, but is preferably 60°C to 120°C, more preferably 80°C to 110°C, since the temperature at the curing fluctuates the relay properties.

In the case where the electronic component is a relay, constituent members (except for a terminal material, a coil, a magnet, etc.) of the relay are mainly made of plastic. Therefore, it is desirable that the one-pack type epoxy resin composition is cured at a low temperature of 120°C or lower. As described above, in the one-pack type epoxy resin composition of the present invention, the epoxy resin adduct compound and the non-latent imidazole compound accelerate curing of dicyandiamide at a low temperature of 120°C or lower. Therefore, the one-pack type epoxy resin composition of the present invention is capable of being adequately cured at a low temperature of 120°C or lower.

The formed material of the relay is a case used for internally storing a switch, a coil, etc. A material of the formed material is not limited to any specific one. As the material, PBT (polybutylene terephthalate) or LCP (liquid crystal polymer) is generally used. PBT is one of engineering plastics, and exhibits excellent thermal stability, dimensional precision, and electric properties. Therefore, PBT is widely used in electric components, electronic components, automobile components, and the like. However, although PBT has high adhesion, PBT has a disadvantage of a low heat resistance. On the other hand, LCP easily provide a heat resistance, excellent strength properties, low thermal expansion properties, and an alignment state because of an alignment of rigid liner chains. However, LCP has a disadvantage of a low adhesion.

There had not been found so far an adhesive exhibiting a favorable adhesion with respect to both of PBT and LCP. However, the one-pack type epoxy resin composition of the present invention is suitably applicable to PBT having a low heat resistance because this one-pack type epoxy resin composition is capable of being cured at a low temperature of 120°C or lower, and is also suitably applicable to LCP having a low adhesion because this one-pack type epoxy resin composition has high sealing ability. Thus, both of PBT and LCP are favorably used as a subject to be adhered by the one-pack type epoxy resin composition of the present invention.

An electronic component such as a relay is mounted on a substrate in such a manner that its metal terminal is fixed onto the substrate by using a solder. In a case where a reflow or flow process is performed using a lead-free solder, a temperature of a solder is increased by 20°C to 30°C from a temperature required in a case of using a conventional solder, and a temperature of the whole of the electronic component increases up to 250°C to 260°C.

In a case of (i) using any single one of dicyandiamide, epoxy resin adduct compound, and the non-latent imidazole compound or (ii) using only two out of these in combination, a one-pack type epoxy resin composition thus obtained has a low heat resistance, and therefore cannot maintain a sealed state of the members adhered to each other, if being subjected to the high-temperature process as above. On the other hand, since the one-pack type epoxy resin composition of the present invention contains, as its essential components, the epoxy resin, dicyandiamide, the epoxy resin adduct compound, and the non-latent imidazole compound, the one-pack type epoxy resin composition of the present invention can maintain airtightness even after a process using a lead-free solder.

Therefore, by causing at least two members to adhere to each other by the one-pack type epoxy resin composition of the present invention, it is possible to provide airtight sealing or insulating sealing for an electronic component without causing a leakage between subject members that are to be adhered to each other. It is possible to confirm whether or not airtight sealing is made in an electronic component by e.g., the sealing (airtightness) test method for control equipment prescribed in the Nippon Electric Control Equipment Industries Association standards (NECA 0404) (Relay Handbook, Kunio MANO, Morikita Publishing Co., Ltd.). Further, it is possible to confirm whether or not insulating sealing is made in an electronic component by e.g., the method for the determination of tracking resistance (JIS C2134).

### Examples

### [Example 1]

A one-pack type epoxy resin composition was prepared by mixing, with respect to 100 parts by weight of bisphenol-A diglycidylether [in Table 1, denoted as "Epoxy Resin (A)"] serving as an epoxy resin, the following curing agents: 10 parts by weight of dicyandiamide [in Table 1, denoted as "Curing Agent (B)"]; 10 parts by weight of an epoxy resin adduct compound (product name: AMICURE (Registered Trademark) MY-24, available from Ajinomoto Fine-Techno Co., Inc.) [in Table 1, denoted as "Curing Agent (C)"]; and 10 parts by weight of 1-cyanoethyl-2-undecylimidazoliumtrimellitate [in Table 1, denoted as "Curing Agent (D)"]. The resultant mixture was further mixed with (i) 1 part by weight of pH 8.0 carbon black (product name: #25, available from Mitsubishi Chemical Corporation) [in Table 1, denoted as "Carbon Black (F)"], (ii) 1 part by weight of an untreated silica (product name: Aerosil 200, available from Nippon Aerosil Co., Ltd.) [in Table 1, denoted as "Inorganic Filler (G)"] which untreated silica has not been subjected to a surface treatment and serves as an inorganic filler, and (iii) 50 parts by weight of calcium carbonate. Subsequently, the resultant mixture was kneaded by using a mixing roll.

As in Fig. 1, the one-pack type epoxy resin composition thus obtained was applied to a surface of a formed member constituting a relay on which surface a one-pack type epoxy resin composition was to be applied. Subsequently, the formed member and a metal terminal were brought into close contact with each other. Then, the one-pack type epoxy resin composition was cured at 100°C for 60 minutes. Thus, a relay was made.

The relay thus made was subjected to a reflow process using a reflow furnace (Toyo corporation, NRY-540S-7Z). Fig. 2 is a graph showing one example of a change in temperature of a solder observed during a reflow process. The horizontal axis represents time, whereas the vertical axis represents a temperature. In this Example, the reflow process (IRS method) was performed under the condition that preheating was performed at 150°C ("T1" in Fig. 2) for 90 seconds to 120 seconds ("t1" in Fig. 2), followed by heating of 200°C ("T2" in Fig. 2) within 30 seconds ("t2" in Fig. 2) with a maximum temperature of 250°C or lower ("T3" in Fig. 2). Details of the IRS method are described in Quality and Reliability HandBook (Sony Corporation, etc.).

After that, the relay was immersed for two minutes in a fluorinated inactive liquid heated to 70°C so that an airtightness evaluation test was performed according to the sealing (airtightness) test method for control equipment prescribed in the Nippon Electric Control Equipment Industries Association standards (NECA 0404) (Relay Handbook, Kunio MANO, Morikita Publishing Co., Ltd.). Then, visual observation was performed. If no bubble occurred during the immersing, the result was determined as "Excellent" or "Good" ("Excellent" represents more excellent airtightness than that represented by "Good"); if a bubble occurred during the immersing, the result was determined as "Poor". Table 1 shows a composition of each one-pack type epoxy resin composition and a result of an airtightness evaluation test conducted thereto.

### [Examples 2 to 8, Comparative Examples 1 to 7]

As shown in Table 1, in each of Examples 2 to 4, a curing agent different from that used in Example 1 was used as Curing Agent (D), and an airtightness evaluation test was conducted in the same manner as in Example 1.

As shown in Table 1, in Example 5, with respect to 50 parts by weight of bisphenol-A diglycidylether, 50 parts by weight of glycerin diglycidylether [in Table 1, denoted as "Wettability Enhancer (E)"] was added. Further, in Example 5, with respect to a total amount (100 parts by weight) of bisphenol-A diglycidylether and glycerin diglycidylether, the same Curing Agents (B) to (D), carbon black, untreated silica, and calcium carbonate as those used in Example 1 were added in the same amounts as those in Example 1, and an airtightness evaluation test was conducted in the same manner as in Example 1.

As shown in Table 1, in Example 6, pH 3.0 (different from that in Example 1) carbon black (product name: MA11, available from Mitsubishi Chemical Corporation) was used, and an airtightness evaluation test was conducted in the same manner as in Example 1.

As shown in Table 1, in Example 7, an inorganic filler different from that in Example 1, i.e., a silica (particle diameter: 10 nm to 50 nm) having been subjected to a surface treatment with octadecyltriethoxysilane was used, and an airtightness evaluation test was conducted in the same manner as in Example 1.

The surface treatment was performed by dissolving octadecyltriethoxysilane in a solvent, hexane, together with catalyst, diethylamine, followed by spraying the resultant onto the silica and heating it to 200°C.

As shown in Table 1, in Example 8, the same carbon black as that used in Example 6 and the same inorganic filler as that used in Example 7 were used, and an airtightness evaluation test was conducted in the same manner as in Example 1.

In each of Comparative Example 1 to 7, components were mixed together in a ratio shown in Table 2, and then an airtightness evaluation test was conducted in the same manner as in Example 1. Note that each numeric value shown in Tables 1 and 2 is expressed in part by weight.

**[Table 1]**

| Component | Name | Ex. 1 | Ex. 2 | Ex. 3 | Ex. 4 | Ex. 5 | Ex. 6 | Ex. 7 | Ex. 8 |
|---|---|---|---|---|---|---|---|---|---|
| Epoxy Resin (A) | Bisphenol-A diglycidylether | 100 | 100 | 100 | 100 | 50 | 100 | 100 | 50 |
| Curing Agent (B) | Dicyandiamide | 10 | 10 | 10 | 10 | 10 | 10 | 10 | 10 |
| Curing Agent (C) | Epoxy resin adduct compound (MY-24) | 10 | 10 | 10 | 10 | 10 | 10 | 10 | 10 |
| Curing Agent (D) Non-Latent Imidazole | 1-cyanoethyl-2-undecylimidazoliumtrimellitate | 10 | - | - | - | 10 | 10 | 10 | 10 |
| | 2-phenylimidazole/isocyanuric acid adduct | - | 10 | - | - | - | - | - | - |
| | 2-undecylimidazole | - | - | 10 | - | - | - | - | - |
| | 2-phenyl-4-methylimidazole | - | - | - | 10 | - | - | - | - |
| Latent Imidazole | 2-phenyl-4-methyl-5-hydroxymethylimidazole | - | - | - | - | - | - | - | - |
| Wettability Enhancer (E) | Glycerin diglycidylether | - | - | - | - | 50 | - | - | 50 |
| Carbon Black (F) | pH 8.0 (#25) | 1 | 1 | 1 | 1 | 1 | - | 1 | - |
| | pH 3.0 (MA11) | - | - | - | - | - | 1 | - | 1 |
| Inorganic Filler (G) | Untreated silica (Aerosil 200) | 1 | 1 | 1 | 1 | 1 | 1 | - | - |
| | Silica (particle diameter: 10 nm to 50 nm) having been subjected to surface treatment with octadecyltriethoxysilane | - | - | - | - | - | - | 1 | 1 |
| Inorganic Filler | Calcium carbonate | 50 | 50 | 50 | 50 | 50 | 50 | 50 | 50 |
| Airtightness Test for Relay | | G. | G. | G. | G. | E. | E. | E. | E. |

| | | | | | | | | | |
|---|---|---|---|---|---|---|---|---|---|
| Abbreviation: "Ex." stands for "Example". "G." stands for "Good". "E." stands for "Excellent". | | | | | | | | | |

**[Table 2]**

| Component | Name | C. Ex. 1 | C. Ex. 2 | C. Ex. 3 | C. Ex. 4 | C. Ex. 5 | C. Ex. 6 | C. Ex. 7 |
|---|---|---|---|---|---|---|---|---|
| Epoxy Resin (A) | Bisphenol-A diglycidylether | 100 | 100 | 100 | 100 | 100 | 100 | 100 |
| Curing Agent (B) | Dicyandiamide | 3 | - | 3 | 3 | - | - | 3 |
| Curing Agent (C) | Epoxy resin adduct compound (MY-24) | - | 10 | 10 | - | 10 | - | 10 |
| Curing Agent (D) Non-Latent Imidazole | 1-cyanoethyl-2-undecylimidazoliumtrimellitate | - | - | - | 10 | 10 | 10 | - |
| | 2-phenylimidazole/isocyanuric acid adduct | - | - | - | - | - | - | - |
| | 2-undecylimidazole | - | - | - | - | - | - | - |
| | 2-phenyl-4-methylimidazole | - | - | - | - | - | - | - |
| Latent Imidazole | 2-phenyl-4-methyl-5-hydroxymethylimidazole | - | - | - | - | - | - | 10 |
| Wettability Enhancer (E) | Glycerin diglycidylether | - | - | - | - | - | - | - |
| Carbon Black (F) | pH 8.0 (#25) | 1 | 1 | 1 | 1 | 1 | 1 | 1 |
| | pH 3.0 (MA11) | - | - | - | - | - | - | - |
| Inorganic Filler (G) | Untreated silica (Aerosil 200) | 1 | 1 | 1 | 1 | 1 | 1 | 1 |
| | Silica [particle diameter: 10 nm to 50 nm] having been subjected to surface treatment with octadecyltriethoxysilane | - | - | - | - | - | - | - |
| Inorganic Filler | Calcium carbonate | 50 | 50 | 50 | 50 | 50 | 50 | 50 |
| Airtightness Test for Relay | | P. | P. | P. | P. | P. | P. | P. |

| | | | | | | | | |
|---|---|---|---|---|---|---|---|---|
| Abbreviation: "C. Ex." stands for "Comparative Example". "P." stands for "Poor". | | | | | | | | |

Tables 1 and 2 show that: only the one-pack type epoxy resin compositions each containing, as its essential components, an epoxy resin, dicyandiamide, an epoxy resin adduct compound, and a non-latent imidazole compound exhibited favorable airtightness; and the one-pack type epoxy resin compositions lacking any of the above essential components could not exhibit airtightness.

Further, as shown in Comparative Example 7, the use of 2-phenyl-4-methyl-5-hydroxymethylimidazole, which is a latent imidazole, as an imidazole compound resulted in occurrence of bubbles, and did not attain the effects of the present invention. This shows that the one-pack type epoxy resin composition of the present invention can exhibit favorable airtightness by including, as its essential components, an epoxy resin, dicyandiamide, an epoxy resin adduct compound, and a non-latent imidazole compound.

Example 5 exhibited more excellent airtightness than that of Example 1, which Example 5 used the one-pack type epoxy resin composition in which a half of the epoxy resin used in Example 1 was replaced with glycerin diglycidylether (wettability enhancer), and conducted the airtightness test for the relay. The reason why such the result was obtained is considered to be that: the wettability enhancer improved the fluidity of the one-pack type epoxy resin composition for a space between the formed member and the metal terminal; and this improved the adhesion.

Example 6 exhibited more excellent airtightness than that of Example 1, which Example 6 used the one-pack type epoxy resin composition to which pH 3.0 carbon black was added instead of pH 8.0 carbon black used in Example 1, and conducted the airtightness test for the relay. The reason why such the result was obtained is considered to be that: since the carbon black used in Example 6 had acidic pH, this carbon black had more excellent dispersibility with respect to the one-pack type epoxy resin composition than that of the carbon black used in Example 1; and this improved the wettability of the one-pack type epoxy resin composition with respect to the members.

Example 7 exhibited more excellent airtightness than that of Example 1, which Example 7 used, as an inorganic filler, the silica (particle diameter: 10 nm to 50 nm) having been subjected to the surface treatment with octadecyltriethoxysilane, instead of the untreated silica used in Example 1, and conducted the airtightness test for the relay. The reason why such the result was obtained is considered to be that: the surface treatment enhanced dispersibility of the inorganic filler used in Example 7 with respect to the one-pack type epoxy resin composition, so as to improve a binding force between the one-pack type epoxy resin composition and the inorganic filler; and this prevented the one-pack type epoxy resin composition from excessively flowing into a part which was not an adhesion surface.

Example 8 replaced a half of the epoxy resin of Example 1 with glycerin diglycidylether of Example 5, used the acidic carbon black of Example 6 instead of the carbon black of Example 1, used the surface-treated silica of Example 7 instead of the untreated silica of Example 1, and conducted the airtightness test for the relay. Example 8 exhibited more excellent airtightness than that of Example 1.

Thus, a one-pack type epoxy resin composition of the present invention contains an epoxy resin, dicyandiamide, an epoxy resin adduct compound, and at least one non-latent imidazole compound.

With this, the one-pack type epoxy resin composition of the present invention is capable of being cured even at a low temperature of 120°C or lower, and has a high heat resistance. Therefore, even in a case where this one-pack type epoxy resin composition is subjected to a reflow process or a flow process using a lead-free solder, the one-pack type epoxy resin composition can provide adequate airtight sealing for an electronic component such as a relay.

The invention being thus described, it will be obvious that the same way may be varied in many ways.

### Industrial Applicability

Since a one-pack type epoxy resin composition of the present invention contains an epoxy resin, dicyandiamide, an epoxy resin adduct compound, and a non-latent imidazole compound, this one-pack type epoxy resin composition is capable of being cured at a low temperature of 120°C or lower, and has a high heat resistance. Therefore, this one-pack type epoxy resin composition can provide adequate airtight sealing or insulating sealing for an electronic component. Thus, a one-pack type epoxy resin composition of the present invention can be widely used in various electronic industries.

## Claims

1. A one-pack type epoxy resin composition comprising an epoxy resin, dicyandiamide, an epoxy resin adduct compound, and at least one non-latent imidazole compound, wherein said at least one non-latent imidazole compound is selected from the group consisting of 1-cyanoethyl-2-methylimidazole, 1-cyanoethyl-2-ethyl-4-methylimidazole, 1-cyanoethyl-2-undecylimidazole, 1-cyanoethyl-2-phenylimidazole, 1-cyanoethyl-2-undecylimidazoliumtrimellitate, 1-cyanoethyl-2- phenylimidazoliumtrimellitate, 2,4-diamino-6-[2'-methylimidazolyl-(1')]-ethyl-s-triazine, a 2-phenylimidazole/isocyanuric acid adduct, 2-methylimidazole, 2-undecylimidazole, 2-phenyl-4-methylimidazole, 1-benzyl-2-methylimidazole, 1-benzyl-2-phenylimidazole, and 1,2-dimethylimidazole, said composition being capable of being cured at a low temperature of 120°C or lower.

2. The one-pack type epoxy resin composition as set forth in claim 1, further comprising a wettability enhancer which has compatibility with an epoxy resin and contains, in a molecule, one or more hydroxyl groups and two or more glycidyl groups.

3. The one-pack type epoxy resin composition as set forth in claim 1, further comprising carbon black having acidic pH.

4. The one-pack type epoxy resin composition as set forth in claim 1, wherein:
the one-pack type epoxy resin composition contains an inorganic filler having an average particle diameter of 10 nm or more but not more than 50 nm;
the inorganic filler has been subjected to a surface treatment with a silane compound; and
the silane compound contains, in a molecule, at least one alkoxyl group bound to a silicon atom and at least one alkyl group bound to a silicon atom, the alkyl group having a main chain whose number of carbon atoms is 16 or more but not more than 20.

5. Use of the one-pack type epoxy resin composition as set forth in claim 1, for adhesion between at least a formed member and a metal terminal in a relay.

6. A relay sealing method, comprising the step of:
causing at least a formed member and a metal terminal of a relay to adhere to each other by a one-pack type epoxy resin composition as set forth in claim 1, for airtight sealing or insulating sealing of the relay.

## Patentansprüche

1. Einzelpaket-Epoxidharzzusammensetzung umfassend ein Epoxidharz, Dicyandiamid, eine Epoxidharzadduktverbindung und mindestens eine nicht-latente Imidazolverbindung, wobei die mindestens eine nicht-latente Imidazolverbindung aus der Gruppe ausgewählt ist, die aus 1-Cyanethyl-2-methylimidazol, 1-Cyanethyl-2-ethyl-4-methylimidazol, 1-Cyanethyl-2-undecylimidazol, 1-Cyanethyl-2-phenylimidazol, 1-Cyanethyl-2-undecylimidazoliumtrimellitat, 1-Cyanethyl-2-phenylimidazoliumtrimellitat, 2,4-Diamino-6-[2'-methylimidazolyl-(1')]-ethyl-s-triazin, einem 2-Phenylimidazol/Isocyanursäureaddukt, 2-Methylimidazol, 2-Undecylimidazol, 2-Phenyl-4-methylimidazol, 1-Benzyl-2-methylimidazol, 1-Benzyl-2-phenylimidazol und 1,2-Dimethylimidazol besteht, wobei die Zusammensetzung bei einer niedrigen Temperatur von 120 °C oder niedriger aushärten kann.

2. Einzelpaket-Epoxidharzzusammensetzung nach Anspruch 1, darüber hinaus einen Benetzbarkeitsverbesserer umfassend, der mit einem Epoxidharz verträglich ist und, in einem Molekül, eine oder mehr Hydroxylgruppen und zwei oder mehr Glycidylgruppen enthält.

3. Einzelpaket-Epoxidharzzusammensetzung nach Anspruch 1, darüber hinaus Ruß mit einem sauren pH-Wert umfassend.

4. Einzelpaket-Epoxidharzzusammensetzung nach Anspruch 1, wobei die Einzelpaket-Epoxidharzzusammensetzung einen anorganischen Füllstoff mit einem durchschnittlichen Teilchendurchmesser von 10 nm oder mehr, aber nicht mehr als 50 nm, enthält,
der anorganische Füllstoff einer Oberflächenbehandlung mit einer Silanverbindung unterzogen wurde, und
die Silanverbindung, in einem Molekül, mindestens eine an ein Siliziumatom gebundene Alkoxylgruppe und mindestens eine an ein Siliziumatom gebundene Alkylgruppe enthält, wobei die Alkylgruppe eine Hauptkette aufweist, deren Anzahl von Kohlenstoffatomen 16 oder mehr, aber nicht mehr als 20, beträgt.

5. Verwendung der Einzelpaket-Epoxidharzzusammensetzung nach Anspruch 1 zur Verbindung mindestens eines Formteils und eines metallischen Anschlussstücks in einem Relais.

6. Ein Relaisabdichtungsverfahren, umfassend den Schritt:
mindestens ein Formteil und ein metallisches Anschlussstück eines Relais mit Hilfe einer Einzelpaket-Epoxidharzzusammensetzung nach Anspruch 1 miteinander eine Verbindung bilden lassen, um das Relais luftdicht abzudichten oder isolierend abzudichten.

## Revendications

1. Composition de résine époxy à emballage unique comprenant une résine époxy, un dicyandiamide, un composé d'addition de résine époxy et au moins un composé imidazole non latent, dans laquelle ledit au moins un composé imidazole non latent est sélectionné dans le groupe constitué de 1-cyanoéthyl-2-méthylimidazole, de 1-cyanoéthyl-2-éthyl-4-méthylimidazole, de 1-cyanoéthyl-2-undécylimidazole, de 1-cyanoéthyl-2-phénylimidazole, de 1-cyanoéthyl-2-undécylimidazoliumtrimellitate, de 1-cyanoéthyl-2-phénylimidazoliumtrimellitate, de 2,4-diamino-6-[2'-méthylimidazolyl-(1')]-éthyl-s-triazine, d'un produit d'addition de 2-phénylimidazole/acide isocyanurique, de 2-méthylimidazole, de 2-undécylimidazole, de 2-phényl-4-méthylimidazole, de 1-benzyl-2-méthylimidazole, de 1-benzyl-2-phenylimidazole et de 1,2-diméthylimidazole, ladite composition pouvant être durcie à une température basse inférieure ou égale à 120 °C.

2. Composition de résine époxy à emballage unique selon la revendication 1, comprenant en outre un améliorateur de mouillabilité qui a une compatibilité avec une résine époxy et contient, dans une molécule, un ou plusieurs groupes hydroxyle et deux groupes glycidyle ou plus.

3. Composition de résine époxy à emballage unique selon la revendication 1, comprenant en outre du noir de carbone ayant un pH acide.

4. Composition de résine époxy à emballage unique selon la revendication 1, dans laquelle :
la composition de résine époxy à emballage unique contient une charge inorganique ayant un diamètre de particule moyen supérieur ou égal à 10 nm, mais pas supérieur à 50 nm ;
la charge inorganique a été soumise à un traitement de surface avec un composé à base de silane ; et
le composé à base de silane contient, dans une molécule, au moins un groupe alcoxyle lié à un atome de silicium et au moins un groupe alkyle lié à un atome de silicium, le groupe alkyle ayant une chaîne principale dont le nombre d'atomes de carbone est supérieur ou égal à 16, mais pas supérieur à 20.

5. Utilisation de la composition de résine époxy à emballage unique selon la revendication 1, pour une adhérence entre au moins un élément formé et une borne métallique dans un relais.

6. Procédé d'étanchéité d'un relais, comprenant l'étape consistant à :
provoquer l'adhérence d'au moins un élément formé et d'une borne métallique d'un relais l'un à l'autre par le biais d'une composition de résine époxy à emballage unique selon la revendication 1, pour le scellage hermétique ou le scellage isolant du relais.
